# EUROPEAN PATENT APPLICATION

(11) **EP 0 751 433 A2**
(43) Date of publication of application: **02.01.1997**
(21) Application number: 96110484.1
(22) Date of filing: 28.06.1996
(51) Int. Cl.: G03F 7/09

(54) **Release composition and photosensitive rubber plate with layer of the same**

(30) Priority: 29.06.1995 JP 186457/95; 23.05.1996 JP 151640/96
(71) Applicant: NIPPON ZEON CO., LTD., Tokyo 100 (JP)
(72) Inventor: Shibuya, Tomohiro, Takaoka-shi, Toyama 933 (JP); Kanzaki, Atsuhiro, Yokohama-shi, Kanagawa 235 (JP); Suzuki, Takao, Narashino-shi, Chiba 275 (JP)
(74) Representative: Kraus, Walter, Dr.

(57) **Abstract**

A release composition for an aqueous processible photosensitive rubber plate, which comprises 100 parts by weight of a water-soluble high-molecular weight compound such as polyvinyl alcohol and 0.5 to 7 parts by weight of an amino alcohol. An aqueous processible photosensitive rubber plate is made by laminating a layer of the release composition on a layer of a photosensitive elastomer composition usually comprising an elastomer, a photopolymerizable ethylenically unsaturated monomer, and a photopolymerization initiator.

## Description

This invention relates to a release composition and a photosensitive rubber plate. More particularly, it relates to a release composition for an aqueous processible photosensitive rubber plate, and to an aqueous processible photosensitive rubber plate having a layer composed of the release composition, which exhibits a reduced adhesion and is substantially free from creases and cracks.

A rubber printing plate for use as a flexographic printing plate, for example, is produced by allowing a negative or positive film to stick onto a surface of a photosensitive printing plate, image-wise exposing a part of a photosensitive layer of the printing plate to actinic radiation, peeling the negative or positive film from the exposed photosensitive printing plate, and washing the photosensitive layer to remove unexposed regions thereof, thereby forming a relief. Generally a release layer is formed on the printing surface of the photosensitive rubber printing plate so that the negative or positive film stuck to the printing surface is easily separated therefrom after the light exposure.

The release layer, however, may suffer from creases and cracks when the rubber printing plate is bent or folded, and such creases and cracks may remain on the surface of the relief, resulting in uneveness of printing ink density on a printed product.

To cope with the above-mentioned difficulty, a composition containing polyvinyl alcohol as a major component is conventionally used for the release layer. For example, a composition comprising polyvinyl alcohol having incorporated therein a plasticizer such as glycerine, sorbitol or ethylene glycol has been proposed in JP-A (Japanese Unexamined Patent Publication) 2-113254 and JP-A 4-130325. It is, however, still difficult with this proposed composition to prevent the occurrence of creases and cracks in the release layer on the rubber printing plate.

In view of the foregoing, a primary object of the present invention is to provide an aqueous processible rubber printing plate which has a reduced adhesion and is substantially free from creases or cracks, and a release composition used for the aqueous processible rubber printing plate.

The present inventors have found that the above-described object can be accomplished by providing a release composition comprising a water-soluble high-molecular weight compound and an amino alcohol.

In one aspect of the present invention, there is provided a release composition for an aqueous processible photosensitive rubber plate, which comprises 100 parts by weight of a water-soluble high-molecular weight compound and 0.5 to 7 parts by weight of an amino alcohol.

In a preferred embodiment of the release composition, the water-soluble high-molecular weight compound is polyvinyl alcohol preferably having a saponification degree of 55 to 98% by mole, and preferably having an average polymerization degree of 500 to 3,000.

In another preferred embodiment of the release composition, the water-soluble high-molecular weight compound has a viscosity of not larger than 30 cp as measured at 20°C on a 4% aqueous solution of this compound by using a Höppler viscometer.

In still another preferred embodiment of the release composition, the amino alcohol has 1 to 10 carbon atoms.

In another aspect of the present invention, there is provided an aqueous processible photosensitive rubber plate comprising a layer of a photosensitive elastomer composition and a layer of the above-specified release composition, said release composition layer being superposed on the photosensitive elastomer layer to form a laminate.

In a preferred embodiment of the aqueous processible photosensitive rubber plate, the photosensitive elastomer composition comprises an elastomer, a photopolymerizable ethylenically unsaturated monomer, and a photopolymerization initiator. Preferably the amounts of the photopolymerizable ethylenically unsaturated monomer and the photopolymerization initiator are 5 to 100 parts by weight and 0.1 to 10 parts by weight, respectively, per 100 parts by weight of the elastomer.

In another preferred embodiment of the aqueous processible photosensitive rubber plate, the elastomer in the photosensitive elastomer composition is selected from those which are readily soluble or dispersible in an aqueous medium or a hydrophilic solvent.

In a further preferred embodiment of the aqueous processible photosensitive rubber plate, the, elastomer in the photosensitive elastomer composition is a mixture of (i) particles of a polymer containing a hydrophilic group, preferably a phosphoric ester group, and (ii) a polymer having no hydrophilic group and exhibiting a rubber elasticity. The amount of the hydrophilic group-containing polymer is preferably 35 to 85 parts by weight based on 100 parts by weight of the elastomer.
Figure 1 is a cross-section showing a laminate form of the aqueous processible photosensitive rubber plate of the present invention; and
Fig. 2 is a cross-section showing another laminate form of the aqueous processible photosensitive rubber plate of the present invention.

The release composition of the present invention comprises a water-soluble high-molecular weight compound and an amino alcohol.

As specific examples of the water-soluble high-molecular weight compound used in the present invention, there can be mentioned polyvinyl alcohol, polyvinyl pyrrolidone, polyacrylic acid, polyacrylamide, polyethylene oxide, polyethylene imine and derivatives of these compounds. Of these polyvinyl alcohol is most preferable in view of the enhanced releasing effect of the release composition.

Polyvinyl alcohol is a product prepared by hydrolysis of polyvinyl acetate which is prepared by polymerization of vinyl acetate. Polyvinyl acetate prepared by polymerizing vinyl acetate by a solution polymerization procedure using an alcohol such as methanol or ethanol is especially preferable for the preparation of polyvinyl alcohol used in the release composition of the present invention in view of the enhanced releasing effect.

The polyvinyl alcohol used in the present invention is usually has an average polymerization degree of 500 to 3,000. If the degree of polymerization is too low, it is difficult to form a layer of the release composition on the photosensitive elastomer composition layer. If the degree of polymerization is too high, the viscosity of the release composition is increased and it is troublesome to form a layer of the release composition on the photosensitive elastomer composition layer. The saponification degree of the polyvinyl alcohol is usually in a range of 55 to 98% by mole, preferably 65 to 95% by mole and more preferably 65 to 85% by mole. With the polyvinyl alcohol having a saponification degree of this range, when the unexposed regions of the rubber plate is removed, the release composition layer is easily separated by an aqueous medium and thus the reproducibility of an image is enhanced.

The water-soluble high-molecular weight compound used in the present invention usually has a viscosity of not higher than 30 cp, preferably in a range of 1 to 25 cp, and more preferably 1 to 15 cp as measured at a temperature of 20°C on a 4% aqueous solution of the water-soluble high-molecular weight compound by using a Höppler viscometer. If the viscosity is too high, it is troublesome to form a layer of the release composition on the photosensitive elastomer composition layer, and the processed rubber plate becomes creased and cracked.

The amino alcohol used in the present invention is an amine compound having a hydroxyl group or groups and usually having 1 to 10 carbon atoms, preferably 1 to 6 carbon atoms. As specific examples of the amino alcohol, there can be mentioned monoethanolamine, diethanolamine, triethanolamine, 2-amino-1-butanol, 2-amino-2-methyl-1-propanol, 2-amino-2-methyl-1,3-propanediol, 2-amino-2-ethyl-1,3-propanediol, ethylmonoethanolamine, dimethylethanolamine, diethylethanolamine, ethyldiethanolamine, buthyldiethanolamine, 3-diethyl amino-1,2-propanediol and 1,1',1''-nitrilotri-2-propanol. Of these amine compounds, those which have three or more hydroxyl groups are preferable. Particularly triethanolamine is most preferable.

The amount of the amino alcohol in the release composition is in a range of 0.5 to 7 parts by weight, preferably 1 to 5 parts by weight, per 100 parts by weight of the water-soluble high-molecular weight compound. If the amount of the amino alcohol is too small, ceases and cracks are likely to occur in the photosensitive rubber plate. In contrast, even if the amount of the amino alcohol exceeds the upper limit, the releasability of a negative or positive film from the printing surface of the rubber plate is not enhanced, it becomes difficult to some extent to form a layer of the release composition on the photosensitive elastomer composition layer, and the processed rubber plate is liable to become creased and cracked.

The manner in which the release composition of the present invention is prepared is not particularly limited. For example, the composition is prepared by dissolving the water-soluble high-molecular weight compound in water or another aqueous medium or a hydrophilic solvent, and adding the amino alcohol in the solution with stirring.

The release composition is coated on a layer of a photosensitive elastomer composition to form a photosensitive rubber plate of a laminate form. The release composition is preferably in a solution form before coating so that it can easily and uniformly be coated on the photosensitive elastomer layer.

The photosensitive elastomer composition used in the present invention has characteristics such that, after it is exposed to actinic radiation, the exposed regions are hardened and the unexposed regions can be washed out with a solvent. Especially a photosensitive elastomer composition such that the unexposed regions are capable of being washed out with water or other aqueous medium or a hydrophilic solvent is suitable for forming a photosensitive rubber plate in combination with the release composition of the present invention.

The photosensitive elastomer composition usually comprises an elastomer, a photopolymerizable ethylenically unsaturated monomer and a photopolymerization initiator.

The elastomer contained in the photosensitive elastomer composition is soluble or dispersible in a solvent. Preferably the elastomer can be readily dissolved or dispersed in an aqueous medium or a hydrophilic solvent. The elastomer capable of being readily dissolved or dispersed in an aqueous medium or a hydrophilic solvent is advantageous as compared with the elastomer soluble or dispersible in an oleophilic (i.e., organophilic) solvent because, when an aqueous medium or a hydrophilic solvent is used, a problem of environmental pollution does not arise and a layer of the release composition of the present invention can be easily formed on the elastomer composition. The aqueous medium used herein includes water and aqueous solutions, and, as the hydrophilic solvent used herein, there can be mentioned, for example, lower alcohols and solutions containing a lower alcohol as a medium.

Of these aqueous mediums and hydrophilic solvents, aqueous solutions are preferable. As examples of solutes contained in the aqueous solutions, there can be mentioned surface active agents, basic compounds such as hydroxides and carbonates of an alkali metal, and acidic compounds such as a mineral acid and an organic acid.

The surface active agents used are not particularly limited. As the surface active agents, there can be mentioned anionic surface active agents, for example, carboxylic acid salts such as sodium laurate, sodium myristate, sodium palmitate, sodium stearate, sodium oleate, potassium laurate, potassium myristate, potassium palmitate, potassium stearate, potassium oleate, N-acyl-N-methylglycine salts, N-acyl-N-methyl-β-alanine salts, N-acylglutamic acid salts, polyoxyethylene alkylether carboxylic acid salts and acylated peptides, sulfonic acid salts such as alkylbenzenesulfonates, alkylnaphthalenesulfonates, naphthalenesulfonates, condensates of a melaminesulfonate with formaldehyde, dialkylsulfosuccinic acid ester salts, alkylsulfoacetate, α-olefinsulfonates and N-acylmethyltaurines, sulfuric acid ester salts such as sulfurized oils, higher alcohol sulfuric acid ester salts, secondary higher alcohol sulfuric acid ester salts, alkylether sulfuric acid salts, secondary higher alcohol ethoxysulfate, polyoxyethylene alkylphenylether sulfuric acid salts, monoglysulfate and a sulfuric acids ester salt of a fatty acid alkylolamide; phosphoric acid esters such as alkylether phosphoric acid ester salts and alkylphosphoric acid ester salts; cationic surface active agents, for example, aliphatic amine salts, aliphatic quaternary ammonium salts, benzalkonium salts, benzethonium chloride, pyridinium salt and imidazolinum salts; amphoteric surface active agents, for example, carboxybetaine, aminocarboxylic acid salts, imidazolinumbetaine and lecithin; and nonionic surface active agents, for example, ethers such as polyoxyethylene alkyl ethers, single chain-length polyoxyethylene alkyl ethers, polyoxyethylene secondary alcohol ethers, polyoxyethylene alkylphenyl ethers, polyoxyethylene sterol ethers, polyoxyethylene lanolin derivatives, ethylene oxide derivatives of an alkylphenol-formaldehyde condensate, polyoxyethylene-polyoxypropylene block copolymers and polyoxyethylene-polyoxypropylene alkyl ethers, etheresters such as polyoxyethylene glycerine fatty acid eaters, polyoxyethylene sorbitan fatty acid eaters and polyoxyethylene sorbitol fatty acid esters, eaters such as polyethylene glycol fatty acid esters, fatty acid monoglycerides, polyglycerine fatty acid esters, sorbitan fatty acid esters, propylene glycol fatty acid esters and sucrose fatty acid esters, and nitrogen-containing compounds such as fatty acid alkanolamides, polyoxyethylene fatty acid amide, polyoxyethylene alkylamines and alkylamine oxides. The surface active agents further include fluorine-containing surface active agents such as fluoroalkylcarboxylic acids, disodium N-perfluorooctanesulfonylglutamate and perfluorooctanesulfonic acid diethanolamide; and reactive surface active agents such as a sulfuric acid ester salt of polyoxyethylene allylglycidyl nonylphenyl ethers and polyoxyethylene allylglycidyl nonylphenyl ethers. Of these, anionic surface active agents and nonionic surface active agents are preferable.

The amount of the surface active agent is usually such that the concentration thereof in the aqueous solution is in a range, of 0.01 to 5% by weight, preferably 0.1 to 2% by weight.

As the elastomer capable of being readily dissolved or dispersed in an aqueous medium or a hydrophilic solvent, there can be mentioned a polymer having hydrophilic groups and exhibiting a rubber elasticity, and a mixture of (i) particles of a polymer having hydrophilic groups and (ii) a polymer having no hydrophilic group and exhibiting a rubber elasticity. Preferably the elastomer is the mixture of (i) particles of a polymer having hydrophilic groups and (ii) a polymer having no hydrophilic group and exhibiting a rubber elasticity. The polymer having hydrophilic groups is preferably a copolymer of a monomer having a hydrophilic group and a monomer having no hydrophilic group, and further preferably has a crosslinked structure. The amount of the particles of a polymer having hydrophilic groups (i) is prefereably 35 to 85 parts by weight, more preferably 50 to 70 parts by weight, based on 100 parts by weight of the elastomer.

As examples of the hydrophilic group, there can be mentioned -OH, -COOH, -NH₂, -SO₃H, -SO₃-, -PO(OH)₂, -PO(OH)-, >PO- and -CN. Of these phosphoric acid ester groups such as -PO(OH)₂, -PO(OH)- and >PO- and -COOH are preferable, and the phosphoric acid ester groups are more preferable.

The copolymer particles having hydrophilic groups are prepared by copolymerizing a monomer having a hydrophilic group and a monomer having no hydrophilic group.

As specific examples of the monomer having a hydrophilic groups there can be mentioned ethylenically unsaturated monocarboxylic acids such as acrylic acid and methacrylic acid, ethylenically unsaturated polycarboxylic acids such as maleic acid, fumaric acid, citraconic acid and itaconic acid, partial esters of ethylenically unsaturated polycarboxylic acids such as monoethyl maleate and monomethyl itaconate, hydroxyalkyl esters of ethylenically unsaturated polycarboxylic acids such as hydroxyethyl acrylate, hydroxypropyl acrylate, hydroxyethyl methacrylate and hydroxypropyl methacrylate, vinyl cyanide monomers such as methacrylonitrile and acrylonitrile, and phosphoric ester group-containing ethylenically unsaturated monomers represented by the following formula: 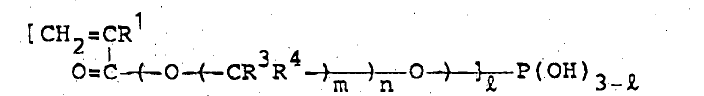 wherein R¹ is hydrogen or a methyl, group, R³ and R⁴ independently represent hydrogen or an alkyl group having 1 to 8 carbon atoms, preferably 1 to 4 carbon atoms, ℓ is an integer of 1 or 2, and m and n independently represent an integer of 1 to 20, which include, for example, 2-acryloxyethyl phosphate, 3-acryloxypropyl phosphate, 2-acryloxypropyl phosphate, 4-acryloxybutyl phosphate, bis(2-acryloxyethyl) phosphate, bis(3-acryloxypropyl) phosphate, bis(4-acryloxybutyl) phosphate, diethylene glycol acrylate phosphate, triethylene glycol acrylate phosphate, polyethylene glycol acrylate phosphate, bis(diethylene glycol acrylate) phosphate, bis(triethylene glycol acrylate) phosphate, bis(polyethylene glycol acrylate) phosphate, 2-methacryloxyethyl phosphate, 3-methacryloxypropyl phosphate, 2-methacryloxypropyl phosphate, 4-methacryloxybutyl phosphate, bis(2-methacryloxyethyl) phosphate, bis(3-methacryloxypropyl) phosphate, bis(4-methacryloxybutyl) phosphate, diethylene glycol methacrylate phosphate, triethylene glycol methacrylate phosphate, polyethylene glycol methacrylate phosphate, bis(diethylene glycol methacrylate) phosphate, bis(triethylene glycol methacrylate) phosphate, bis(polyethylene glycol methacrylate) phosphate. As other examples of the monomer having a hydrophilic group, there can be mentioned sodium styrenesulfonate, and ethylenically unsaturated aminoalkyl esters such as t-butylaminoethyl acrylate, N,N-diethylaminoethyl acrylate, N,N-dimethylaminoethyl acrylate, t-butylaminoethyl methacrylate, N,N-diethylaminoethyl methacrylate and N,N-dimethylaminoethyl methacrylate. Of these hydrophilic group-having monomers, phosphoric ester group-containing ethylenically unsaturated monomers and ethylenically unsaturated carboxylic acids are preferable, and 2-acryloxyethyl phosphate, 2-acryloxypropyl phosphate, 2-methacryloxyethyl phosphate and 2-methacryloxypropyl phosphate, are more preferable.

The amount of the monomer having a hydrophilic group is in a range of 5 to 30% by weight, preferably 5 to 20% by weight, based on the total weight of the monomers used for the preparation of the copolymer particles. If the amount of the hydrophilic group-having monomer is smaller than 5% by weight, the rate of dissolution or dispersion of the photosensitive elastomer composition in an aqueous medium tends to be reduced. In contrast, if the amount of the hydrophilic group-having monomer is larger than 30% by weight, the processability of the photosensitive elastomer composition and the resistance of the printing plate to an aqueous ink are reduced.

As specific examples of the monomer having no hydrophilic group, there can be mentioned aromatic vinyl monomers such as styrene, o-methylstyrene, m-methylstyrene, p-methylstyrene, p-tert-butylstyrene, 1,3-dimethylstyrene, chlorostyrene, vinylnaphthalene and vinylanthrathene, ethylenically unsaturated carboxylic acid alkyl esters such as methyl acrylate, ethyl acrylate, propyl acrylate, n-amyl acrylate, isoamyl acrylate, hexyl acrylate, ethylhexyl acrylate, octyl acrylate, glycidyl acrylate, methyl methacrylate, ethyl methacrylate, propyl methacrylate, n-amyl methacrylate, isoamyl methacrylate, hexyl methacrylate, ethylhexyl methacrylate, octyl methacrylate and glycidyl methacrylate, ethylenically unsaturated glycidyl ethers such as allyl glycidyl ether, conjugated dienes such as 1,3-butadiene, isoprene, 2,3-dimethyl-1,3-butadiene, 1,3-pentadiene, 1,3-hexadiene and chloroprene; and non-conjugated polyenes, for example, aromatic polyvinyl monomers such as divinylbenzene and trivinylbenzene, and acrylic esters or methacrylic esters of polyhydric alcohols such as ethylene glycol diacrylate, trimethylolpropane triacrylate, propylene glycol diacrylate, ethylene glycol dimethacrylate and propyleneglycol dimethacrylate.

Of these, conjugated dienes, especially 1,3-butadiene and isoprene are preferable in view of good and balanced elasticity and strength. The amount of a conjugated diene is usually in a range of 40 to 90% by weight, preferably 50 to 80% by weight, based on the total weight of the monomers for the copolymer particles having hydrophilic groups. If the amount of a conjugated diene is too small, the strength and elasticity of the photosensitive elastomer composition are reduced. In contrast, if the amount of a conjugated diene is too large, the rate of dissolution or dispersion of the photosensitive elastomer composition in an aqueous medium or a hydrophilic solvent is reduced.

Further, to enhance the transparency and processability of the photosensitive elastomer composition and the strength and elasticity of the rubber printing plate, a non-conjugated diene is preferably used in addition to the above-specified monomers. Ethylene glycol dimethacrylate and divinylbenzene are especially preferable as the non-conjugated diene. The amount of a non-conjugated diene is usually, not larger than 10% by weight based on the total weight of the monomers for the copolymer particles having hydrophilic groups.

As examples of the copolymer having no hydrophilic groups and exhibiting a rubber elasticity, there can be mentioned a block copolymer comprising a polystyrene block A and a polybutadiene block B, a block copolymer comprising a polystyrene block A and a polyisoprene block B, an SB random copolymer comprising, styrene units and butadiene units as the essential monomer units, an NB random copolymer comprising acrylonitrile units and butadiene units as the essential monomer units, a styrene-isoprene random copolymer, a methyl methacrylate-butadiene random copolymer, polybutadiene, polyisoprene and natural rubber.

Of these copolymers, block copolymers having conjugated diene monomer units are preferable. The structure of the block copolymer is not particularly limited, and there can be mentioned, for example, those, which are represented by the formulae: (A-B)ₙ-A, (A-B)ₙ-AB, B-(A-B)ₙ-A-B, (A-B)ₙ-X, ((A-B)ₙ-A)ₘ-X, (B-A-(B-A)ₙ)ₘ-X and (B-A-(B-A)ₙ-B)ₘ-X wherein A represents polymer block A, B represents polymer block B, X represents a coupling agent or a residual group of a polyfunctional ionic polymerization initiator, and n and m are integers of at least 1, preferably in a range of 1 to 5. As specific examples of the coupling agent, there can be mentioned tin tetrachloride, silicon tetrachloride, epoxidized esters, polyvinyl compounds, carboxylic acid esters and poly(halogenated hydrocarbon). As examples of the polyfunctional ionic polymerization initiator, there can be mentioned a polyfunctional organic lithium compound. Of the block copolymers, a block copolymer consisting of polystyrene block A and polybutadiene block B and a block copolymer consisting of polystyrene block A and polyisoprene block B are especially preferable.

The photopolymerizable ethylenically unsaturated monomer used is such that the polymerization thereof is initiated by the action of a photopolymerization initiator.

As specific examples of the photpolymerizable ethylenically unsaturated monomer, there can be mentioned aromatic vinyl monomers such as styrene, o-methylstyrene, m-methylstyrene, p-methylstyrene, p-tert-butylstyrene, 1,3-dimethylstyrene, chlorostyrene, vinylnaphthalene, vinylanthracene, divinylbenzene and trivinylbenzene; ethylenically unsaturated nitrile monomers such as acrylonitrile and methacrylonitrile; ethylenically unsaturated carboxylic acid esters such as methyl acrylate, ethyl acrylate, propyl acrylate, n-amyl acrylate, isoamyl acrylate, hexyl acrylate, ethylhexyl acrylate, octyl acrylate, glycidyl acrylate, methyl methacrylate, ethyl methacrylate, propyl methacrylate, n-amyl methacrylate, isoamyl methacrylate, hexyl methacrylate, ethylhexyl methacrylate, octyl methacrylate, hydroxyethyl acrylate, hydroxypropyl acrylate, hydroxyethyl methacrylate, hydroxypropyl methacrylate, glycidyl methacrylate, ethylene glycol diacrylate, trimethylolpropane triacrylate, 1,4-butanediol diacrylate, 1,4-butanediol dimethacrylate, propylene glycol diacrylate, 1,6-hexanediol diacrylate, 1,6-hexanediol dimethacrylate, methoxyethylene glycol acrylate, methoxyethylene glycol methacrylate, methoxypropylene glycol acrylate, methoxypropylene glycol methacrylate, diethyl maleate, dimethyl itaconate, 1,7-heptanediol diacrylate, 1,7-heptanediol dimethacrylate, 1,8-octanediol diacrylate, 1,8-octanediol dimethacrylate, 1,9-nonanediol diacrylate, 1,9-nonanediol dimethacrylate, 1,10-decanediol diacrylate, 1,10-decanediol dimethacrylate, 1,12-dodecanediol diacrylate, 1,12-dodecanediol dimethacrylate, 1,14-tetradecanediol diacrylate, 1,14-tetradecanediol dimethacrylate, 1,7-heptanediol monoacrylate, 1,7-heptanediol monomethacrylate, 1,8-octanediol monoacrylate, 1,8-octanediol monomethacrylate, 1,9-nonanediol monoacrylate, 1,9-nonanediol monomethacrylate, 1,10-decanediol monoacrylate, 1,10-decanediol monomethacrylate, 1,12-dodecanediol monoacrylate, 1,12-dodecanediol monomethacrylate, 1,14-tetradecanediol monoacrylate and 1,14-tetradecanediol monomethacrylate; ethylenically unsaturated glycidyl ethers such as ally glycidyl ether; ethylenically unsaturated monocarboxylic acids such acrylic acid and methacrylic acid; ethylenically unsaturated polycarboxylic acids such as maleic acid, fumaric acid, citraconic acid and itaconic acid; partial esters of ethylenically unsaturated polycarboxylic acids such as monoethyl maleate and monomethyl itaconate; and phosphoric ester group-containing ethylenically unsaturated monomers such as 2-acryloxyethyl phosphate, 3-acryloxypropyl phosphate, 2-acryloxypropyl phosphate, 4-acryloxybutyl phosphate, bis(2-acryloxyethyl) phosphates bis(3-acryloxypropyl) phosphate, bis(4-acryloxybutyl) phosphate, diethylene glycol acrylate phosphate, triethylene glycol acrylate phosphate, bis(diethylene glycol acrylate) phosphate, bis(triethylene glycol acrylate) phosphate, bis(polyethylene glycol acrylate) phosphate, 2-methacryloxyethyl phosphate, 3-methacryloxypropyl phosphate, 2-methacryloxypropyl phosphate, 4-methacryloxybutyl phosphate, bis(2-methacryloxyethyl) phosphate, bis(3-methacryloxypropyl) phosphate, bis(4-methacryloxybutyl) phosphate, diethylene glycol methacrylate phosphate, triethylene glycol methacrylate phosphate, bis(diethylene glycol methacrylate) phosphate, bis(triethylene glycol methacrylate) phosphate and bis(polyethylene glycol methacrylate) phosphate. The amount of the photopolymerizable ethylenically unsaturated monomer is usually in a range of 5 to 100 parts by weight, preferably 10 to 50 parts by weight, per 100 parts by weight of the elastomer.

The photopolymerization initiator used is such that, when it is irradiated with actinic radiation such as ultraviolet rays, free radicals are produced whereby the polymerization of the ethylenically unsaturated monomer is initiated. As specific examples of the photopolymerization initiator, there can be mentioned α-diketones such as diacetyl and benzil, acyloins such as benzoin and pivaloin, acyloin ethers such as benzoin methyl ether, benzoin ethyl ether and benzoin isopropyl ether; and polynuclear quinones such as anthraquinone and 1,4-naphthoquinone.

The amount of the photopolymerization initiator is usually in a range of 0.1 to 10 parts by weight, preferably 1 to 7 parts by weight, per 100 parts by weight of the elastomer. If the amount of the photopolymerization initiator is smaller than 0.1 part by weight, the photosensitive elastomer composition is cured not to a satisfying extent and the printing rubber plate has a poor strength. In contrast, if the amount of the photopolymerization initiator is larger than 10 parts by weight, the rate of photopolymerization is lowered.

If desired, additives such as a plasticizer, a preservative stabilizer and an antiozonant can be incorporated in the photosensitive elastomer composition.

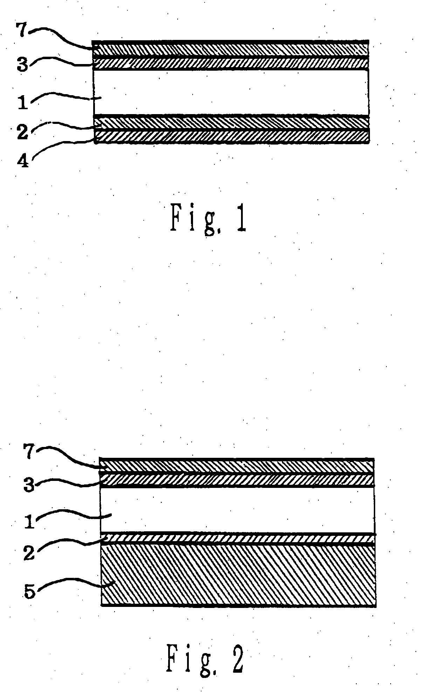

The photosensitive rubber plate of the present invention comprises a layer of a photosensitive elastomer composition and a layer of a release composition, laminated on the photosensitive elastomer composition layer. More specifically, as illustrated in the attached drawings, a layer 1 of a photosensitive elastomer composition is superposed on and united to an optional base film 4 (Fig. 1) or an optional supporting plate 5 (Fig. 2) by an adhesive layer 2 intervening between the layer 1 and the film 4 or plate 5. A layer 3 of a release composition is laminated on a side of the photosensitive elastomer composition layer 1, which is opposite to the side united to the base film 4 or the supporting film 5. Optionally, a protector film 7 is laminated on the release composition layer 3.

The lamination of the release composition layer 3 is usually conducted by casting a solution of the release composition on the photosensitive elastomer composition layer 1 and allowing the cast solution to stand, or by casting a solution of the release composition on a glass sheet surrounded by a frame or on a protector film to form a film of the release composition, and sticking the film on the photosensitive elastomer composition layer 1.

The thickness of the release composition layer 3 is usually in a range of 0.1 to 10 µm, preferably 0.5 to 5 µm. If the release composition layer is too thick, an original image film becomes difficult to uniformly attach onto the photosensitive rubber plate. If the release composition layer 3 is too thin, the effect of enhancing releasing property of an attached original image film is undesirably reduced.

The protector film 7 has a function of preventing the release composition layer 3 and the photosensitive elastomer layer 1 from being distorted by external force during transportation or storage of the photosensitive rubber plate. The protector film 7 is peeled off before an original image film is attached to the photosensitive rubber plate.

The protector film is made of a flexible resin which includes, for example, polyethylene terephthalate, polyethylene, polypropylene and polystyrene. Preferably a release layer is provided on a surface of the protector film, which is to be placed in contact with the layer of the release composition of the present invention on the photosensitive elastomer composition. By the provision of the relaese layer, the peeling-off of the protector film from the photosensitive rubber plate is facilitated. The release layer is usually formed from a silicone resin, an alkyd resin or a urethane resin. The protector film usually has a thickness of 75 to 200 µm, preferably 100 to 150 µm. If the thickness of the protector film is too small, the film has a poor mechanical strength and is easily distorted. In contrast, if the thickness of the protector film is too large, the strength of the protector film is too high and the peeling-off of the film from the photosensitive rubber plate becomes difficult.

On the surface of the photosensitive rubber plate, which is opposites to the surface on which the layer of the release composition is formed, a layer of an adhesive composition is formed so that the photosensitive rubber plate is firmly stuck to a printing roll or a supporting plate. By the formation of the adhesive composition layer, when the photosensitive rubber plate is adhered onto a printing roll or other supporting means, the photosensitive rubber plate exhibits an enhanced dimensional stability, securing improved printing precision.

The adhesive composition contains a polymeric material capable of being swollen or dissolved in an oleophilic solvent. As specific examples of the polymeric material, there can be mentioned a polystyrene-polyisoprene-polystyrene, block copolymer, a polystyrene-polybutadiene-polystyrene block copolymer, a styrene-butadiene copolymer, polybutadiene, polychloroprene, polybutadiene having carboxyl groups or epoxy groups in the molecule, a methacrylic acid-acrylic acid ester copolymer, a methacrylic acid ester-acrylic, acid copolymer and an acrylic acid ester-acrylonitile copolymer.

A base film is laminated on a surface of the photosensitive rubber plate, which is opposite to the surface on which the layer of the release composition of the present invention is formed. The base film is adhered to the photosensitive rubber plate either directly or through an adhesive composition layer between the rubber plate and the base film. The base film is made of a flexible resin which includes, for example, polyethylene terephthalate, polypropylene, polyimide and polyamide.

After processing of the photosensitive rubber plate, the resulting printing plate having the base film laminated thereon is used for printing as it is. When a photosensitive rubber plate having a relatively large thickness is required for printing a thick article such as a corrugated board, the base film is peeled off therefrom and, in substitution therefor, a supporting plate is adhered onto the rubber plate. To facilitate peeling-off of the base film from the rubber plate, a release layer is preferably formed on a surface of the base film, which is placed in contact with the adhesive composition layer, before the base film is adhered onto the photosensitive rubber plate. The release layer is usually formed from a resin which includes, for example, a silicone resin, an alkyd resin or a urethane resin.

As illustrated in Fig. 2, the adherence of the supporting plate 5 to the rubber plate is effected so that the supporting plate 5 is placed in contact with the adhesive composition layer 2 of the rubber plate. The thus-made laminate structure of the rubber plate with the supporting plate is used as a printing plate for flexographic printing.

The supporting plate is usually made of an elastomer which includes, for example, natural rubber, synthetic rubber or a plasticized vinyl chloride resin. The supporting plate may also be made of a foamed material so that the printing pressure can be adjusted as desired. The thickness of the supporting plate is usually in a range of 2 to 9 mm, preferably 3 to 7 mm.

The photosensitive rubber plate constructed according to the present invention hag a release composition layer comprising a water-soluble high-molecular weight compound, and thus, exhibits a desirably reduced adherence. For an unknown reason, by forming the release composition layer comprising a water-soluble high-molecular weight compound and an amino alcohol on a photosensitive rubber plate, occurrence of creases and cracks are prevented or minimized when the rubber plate is bent.

The invention will now be described more in detail by the following examples that by no means limit the scope of the invention. Parts and % in the examples and comparative examples are by weight unless otherwise specified.

Resistance of a photosensitive rubber plate to cracks was evaluated by the following method.

A specimen of a photosensitive rubber plate having a thickness of 3 mm was wound around a cylindrical roll having a diameter of 5.2 mm, and the surface condition of the rubber plate was visually observed and expressed by the following five ratings.
- Rating 5: No cracks were found.
- Rating 4: A few small cracks were found.
- Rating 3: A lot of small cracks were found.
- Rating 2: A few large cracks were found.
- Rating 1: A lot of large cracks were found.

### Example 1

A mixture of 65 parts of phosphate eater group-containing random, copolymer comprising 60% of butadiene units, 9% of methyl acrylate units, 20% of 2-methacryloxyethyl phosphate units, 10% of styrene units and 1% of divinylbenzene units, 35 parts of a polystyrene-polybutadiene-polystyrene block copolymer, 50 parts of liquid polybutadiene ("Nisso PB B1000" supplied by Nippon Soda Co., Ltd.) and 0.2 part of 2,6-di-t-butyl-p-cresol was kneaded together at 150°C using a kneader to give a uniform mixtures. The temperature was lowered to 120°C, and 15 parts of 1,7-heptanediol dimethacrylate, 1 part of benzoin methyl ether and 0.02 part of methylhydroquinone were added to the mixture. The thus-obtained mixture was further kneaded together to give a photosensitive elastomer composition.

In 90 parts of water, 10 parts of polyvinyl alcohol having a saponification degree of 70% by mole and a Höppler viscosity of 8 cp as measured on a 4% aqueous solution at 20°C was dissolved, and then 0.3 part of triethanolamine was added to the aqueous polyvinyl alcohol solution to give a release composition.

A silicone-coated polyethylene terephthalate film having a thickness of 125 µm (hereinafter referred to as "protector film" when appropriate) was coated with the above-mentioned release composition by using a 1/1000 inch coater, and the film was allowed to stand at 110°C for 1 minute in a dryer whereby, a film of the release composition having a thickness of approximately 3 µm (hereinafter referred to as "slip film" when appropriate) was formed on the polyethylene terephthalate film.

In 100 parts of toluene, 100 parts of a block copolymer composed of polystyrene blocks and polybutadiene blocks ("Kraton TR-1101" supplied by Shell Chemical Co.) and 10 parts of 1,6-hexanediol dimethacrylate were dissolved to prepare a solution of an adhesive composition having a solid content of 47.6%. A silicone-coated polyethylene terephthalate film having a thickness of 125 µm (hereinafter referred to as "base film" when appropriate) was coated with the adhesive composition solution by using a 0.1 mm-interval bar coater. Then the coating was allowed to stand at room temperature for 10 minutes and further stand at 70°C for 5 minutes in a dryer whereby a layer of the adhesive composition having a thickness of approximately 50 µm was formed on the polyethylene terephthalate film.

The above-mentioned photosensitive elastomer composition was sandwiched between two polyethylene terephthalate films each having a thickness of 125 µm (hereinafter referred to as "forming film" when appropriate) to form a plate having a thickness of 3 mm by using a vacuum press machine. The two forming films adhered to a plate-form photosensitive elastomer composition. One of the forming films was peeled off from the plate-form photosensitive rubber composition, and then the above-mentioned protector film having the slip film laminated thereon was superposed on the plate-form photosensitive elastomer composition so that the slip film was placed in contact with the exposed surface of the photosensitive elastomer composition. The superposed photosensitive elastomer composition and films were pressed together by using a roller. Then the other forming film was peeled off from the plate-form photosensitive elastomer composition, and the base film having the adhesive composition layer formed thereon was superposed on the plate-form photosensitive elastomer composition so that the adhesive composition layer was placed in contact with the exposed surface, of the photosensitive elastomer composition. The superposed photosensitive elastomer composition and films were pressed together by using a roller to give a photosensitive rubber plate.

The photosensitive rubber plate was composed of the plate-form photosensitive elastomer composition having the adhesive composition layer and the slip film, which were stuck on both surfaces of the photosensitive elastomer composition. When the base film and the protector film were peeled off from the plate-form photosensitive elastomer composition, the base film and the protector film could be easily separated, but the adhesive composition layer and the slip film were not released. When the crack resistance of the photosensitive rubber plate was evaluated, the rubber plate got rating 5.

### Examples 2 and 3

Photosensitive rubber plates were made by the same procedures as described in Example 1 except that monoethanolamine was used in Example 2 and ethyl diethanolamine was used in Example 3 instead of triethanolamine used in Example 1. When the crack resistance was evaluated, the two photosensitive rubber plates got rating 4.

### Example 4

A photosensitive rubber plate was made by the same procedures as described in Example 1 except that the amount of triethanolamine used in Example 1 was changed to 0.08 part. When the crack resistance was evaluated, the photosensitive rubber plate got rating 4.

### Comparative Example 1

A photosensitive rubber plate was made by the same procedures as described in Example 1 except that triethanolamine used in Example 1 was not used in this comparative example. When the crack resistance was evaluated, the photosensitive rubber plate got rating 2.

### Comparative Example 2

A photographic rubber, plate was made by the same procedures as described in Example 1 except that glycerine was used instead of triethanolamine used in Example 1. When the crack resistance was evaluated, the photosensitive rubber plate got rating 3.

### Comparative Example 3

A photosensitive rubber plate was made by the same procedures as described in Example 1 except that the amount of triethanolamine used in Example 1 was changed to 1.5 parts. When the crack resistance was evaluated, the photosensitive rubber plate got rating 3. The photosensitive rubber plate exhibited undesirably large tackiness, and, when an original image film was attached thereto and the photosensitive rubber plate was exposed to actinic radiation, the image film could not easily peeled off from the rubber plate.

As seen from the above results, a photosensitive rubber plate having laminated thereon a release composition layer comprising a water-soluble high-molecular weight compound but not containing an amino alcohol tends to suffer from creases and cracks. Even with a release composition layer comprising a water-soluble high-molecular weight compound and glycerine, the photosensitive rubber plate still suffers from creases and cracks. In contrast, a photosensitive rubber plate having laminated thereon a release composition layer of the present invention comprising a water-soluble high-molecular weight compound and an amino alcohol is substantially free from creases and cracks.

## Claims

1. A release composition for an aqueous processible photosensitive rubber plate, which comprises 100 parts by weight of a water-soluble high-molecular weight compound and 0.5 to 7 parts by weight of an amino alcohol.

2. The release composition as claimed in claim 1, wherein the water-soluble high-molecular weight compound is polyvinyl alcohol.

3. The release composition as claimed in claim 2, wherein the polyvinyl alcohol has an average polymerization degree of 500 to 3,000.

4. The release composition as claimed in claim 2 or 3, wherein the polyvinyl alcohol has a saponification degree of 55 to 98% by mole.

5. The release composition as claimed in any of claims 1 to 4, wherein the water-soluble high-molecular weight compound has a viscosity of not larger than 30 cp as measured at 20°C on a 4% aqueous solution of the compound by using a Höppler viscometer.

6. The release composition as claimed in any of claims 1 to 5, wherein, the amino alcohol has 1 to 10 carbon atoms.

7. An aqueous processible photosensitive rubber plate comprising a layer of a photosensitive elastomer composition and a layer of a release composition; said release composition layer being superposed on the photosensitive elastomer layer to form a laminate, and said release composition comprising 100 parts by weight of a water-soluble high-molecular weight compound and 0.5 to 7 parts by weight of an amino alcohol.

8. The aqueous processible photosensitive rubber plate as claimed in claim 7, wherein the water-soluble high-molecular weight compound in the release composition is polyvinyl alcohol.

9. The aqueous processible photosensitive rubber plate as claimed in claim 8, wherein the polyvinyl alcohol has an average polymerization degree of 500 to 3,000.

10. The aqueous processible photosensitive rubber plate as claimed in claim 8 or 9, wherein the polyvinyl alcohol has a saponification degree of 55 to 98% by mole.

11. The aqueous processible photosensitive rubber plate as claimed in any of claims 7 to 10, wherein the water-soluble high-molecular weight compound in the release composition has a viscosity of not larger than 30 cp as measured at 20°C on a 4% aqueous solution of the compound by using a Höppler viscometer.

12. The aqueous processible photosensitive rubber plate as claimed in any of claims 7 to 11, wherein the amino alcohol in the release composition has 1 to 10 carbon atoms.

13. The aqueous processible photosensitive rubber plate as claimed in any of claims 7 to 12, wherein said photosensitive elastomer composition comprises an elastomer, a photopolymerizable ethylenically unsaturated monomer, and a photopolymerization initiator.

14. The aqueous processible photosensitive rubber plate as claimed in claim 13, wherein the amounts of the photopolymerizable ethylenically unsaturated monomer and the photopolymerization initiator in the photosensitive elastomer composition are 5 to 100 parts by weight and 0.1 to 10 parts by weight, respectively, per 100 parts by weight of the elastomer.

15. The aqueous processible photosensitive rubber plate as claimed in claim 13 or 14, wherein said elastomer in the photosensitive elastomer composition is selected from those which are readily soluble, or dispersible in an aqueous medium or a hydrophilic solvent.

16. The aqueous processible photosensitive rubber plate as claimed in any of claims 13 to 15, wherein said elastomer in the photosensitive elastomer composition is a mixture of (i) particles of a polymer containing a hydrophilic group, and (ii) a polymer having no hydrophilic group and exhibiting a rubber elsticity.

17. The aqueous processible photosensitive rubber plate as claimed in claims 16, wherein the amount of the particles of a polymer containing a hydrophilic group is 35 to 85 parts by weight based on 100 parts by weight of the elastomer.

18. The aqueous processible photosensitive rubber plate as claimed in claim 16 or 17, wherein the polymer containing a hydrophilic group is a copolymer containing a phosphoric ester group as the hydrophilic group.

19. The aqueous processible photosensitive rubber plate as claimed in any of claims 16 to 18, wherein said polymer having no hydrophilic group and exhibiting a rubber elsticity is a block copolymer containing a polymer block derived from a conjugated diene.
